# EUROPEAN PATENT APPLICATION

(11) **EP 4 412 440 A1**
(43) Date of publication of application: **07.08.2024**
(21) Application number: 24150244.2
(22) Date of filing: 03.01.2024
(51) Int. Cl.: H10N 97/00, H10B 12/00

(54) **CAPACITOR STRUCTURE AND SEMICONDUCTOR DEVICE INCLUDING THE CAPACITOR STRUCTURE**

(30) Priority: 20.01.2023 KR 20230008523
(71) Applicant: Samsung Electronics Co., Ltd., Suwon-si, Gyeonggi-do 16677 (KR)
(72) Inventor: LEE, Jinsu, 16677 Suwon-si (KR); KANG, Jungwoo, 16677 Suwon-si (KR); HAN, Donguk, 16677 Suwon-si (KR); KIM, Hayeong, 16677 Suwon-si (KR); LIM, Yirang, 16677 Suwon-si (KR)
(74) Representative: Marks & Clerk LLP

(57) **Abstract**

A capacitor structure includes a lower electrode; a dielectric pattern on a sidewall of the lower electrode; and an upper electrode structure, the upper electrode structure including a first upper electrode and a second upper electrode sequentially stacked on a sidewall of the dielectric pattern, wherein each of the first upper electrode and the second upper electrode includes a metal nitride, and the metal nitride included in the first upper electrode has a crystal orientation that is different from a crystal orientation of the metal nitride included in the second upper electrode, and a work function of the first upper electrode is greater than a work function of the second upper electrode.

## Description

### BACKGROUND

### 1. Field

Embodiments relate to a capacitor structure and a semiconductor device including the capacitor structure.

### 2. Description of the Related Art

A capacitor in a DRAM device may include a lower electrode, a dielectric layer, and an upper electrode sequentially stacked. As the integration degree of the DRAM device increases, a thickness of the upper electrode may become smaller, and accordingly, leakage current may increase. Thus, preventing leakage current of the upper electrode as well as securing low resistance of the upper electrode are needed.

### SUMMARY

The embodiments may be realized by providing a capacitor structure including a lower electrode; a dielectric pattern on a sidewall of the lower electrode; and an upper electrode structure, the upper electrode structure including a first upper electrode and a second upper electrode sequentially stacked on a sidewall of the dielectric pattern, wherein each of the first upper electrode and the second upper electrode includes a metal nitride, and the metal nitride included in the first upper electrode has a crystal orientation that is different from a crystal orientation of the metal nitride included in the second upper electrode, and a work function of the first upper electrode is greater than a work function of the second upper electrode.

The embodiments may be realized by providing a capacitor structure including a lower electrode; a dielectric pattern on a sidewall of the lower electrode; and an upper electrode structure, the upper electrode structure including a first upper electrode and a second upper electrode sequentially stacked on a sidewall of the dielectric pattern, wherein each of the first upper electrode and the second upper electrode includes titanium nitride, a primary crystal orientation of the titanium nitride of the first upper electrode is [111], and a primary crystal orientation of the titanium nitride of the second upper electrode is [200].

The embodiments may be realized by providing a semiconductor device including a substrate; an active pattern on the substrate; a gate structure extending in a first direction through an upper portion of the active pattern, the first direction being substantially parallel to an upper surface of the substrate; a bit line structure on a central portion of the active pattern, the bit line structure extending in a second direction substantially parallel to the upper surface of the substrate and substantially perpendicular to the first direction; a contact plug structure on each of opposite edge portions of the active pattern; and a capacitor structure on the contact plug structure, wherein the capacitor structure includes a lower electrode; a dielectric pattern on a sidewall of the lower electrode; and an upper electrode structure, the upper electrode structure including a first upper electrode and a second upper electrode sequentially stacked on a sidewall of the dielectric pattern, each of the first upper electrode and the second upper electrode includes a metal nitride, the metal nitride included in the first upper electrode has a crystal orientation that is different from a crystal orientation of the metal nitride included in the second upper electrode, and a work function of the first upper electrode is greater than a work function of the second upper electrode.

At least some of the above and other features of the invention are set out in the claims.

### BRIEF DESCRIPTION OF THE DRAWINGS

Features will be apparent to those of skill in the art by describing in detail embodiments with reference to the attached drawings in which:
FIG. 1 is a cross-sectional view illustrating a first capacitor structure according to example embodiments.
FIGS. 2 to 6 are cross-sectional views of stages in a method of forming a first capacitor structure in accordance with example embodiments.
FIG. 7 is a cross-sectional view illustrating a second capacitor structure in accordance with example embodiments.
FIG. 8 is a plan view illustrating a semiconductor device in accordance with example embodiments, and FIG. 9 is a cross-sectional view taken along line A-A' of FIG. 8.
FIGS. 10 to 25 are plan views and cross-sectional views of stages in a method of manufacturing a semiconductor device according to example embodiments.

### DETAILED DESCRIPTION

The above and other aspects and features of the capacitor structures and the methods of manufacturing the same, the semiconductor devices including the capacitor structures and the methods of manufacturing the same in accordance with example embodiments will become readily understood from detail descriptions that follow, with reference to the accompanying drawings. It will be understood that, although the terms "first," "second," and/or "third" may be used herein to describe various materials, layers, regions, pads, electrodes, patterns, structure and/or processes, these various materials, layers, regions, pads, electrodes, patterns, structure and/or processes should not be limited by these terms. These terms are only used to distinguish one material, layer, region, pad, electrode, pattern, structure or process from another material, layer, region, pad, electrode, pattern, structure or process, and are not intended to imply or require sequential inclusion. Thus, "first", "second" and/or "third" may be used selectively or interchangeably for each material, layer, region, electrode, pad, pattern, structure or process respectively. As used herein, the term "or" is not necessarily an exclusive term, e.g., "A or B" would include A, B, or A and B.

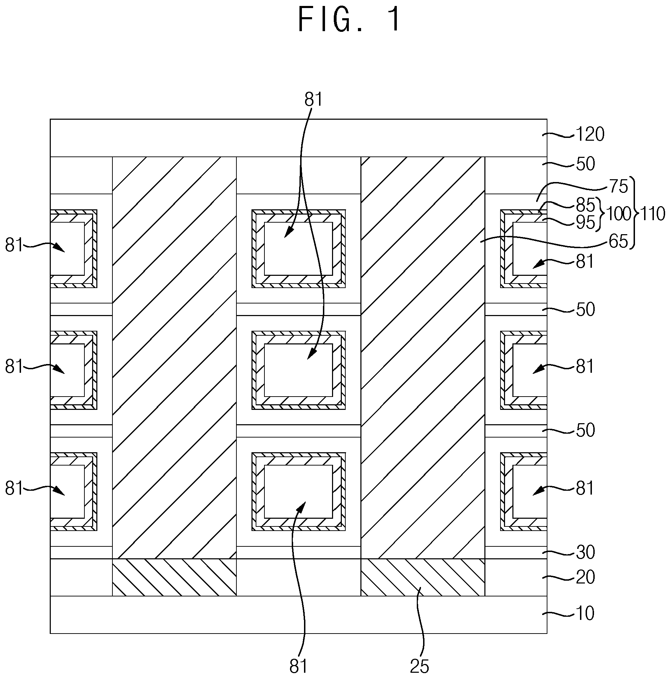

FIG. 1 is a cross-sectional view illustrating a first capacitor structure according to example embodiments.

The first capacitor structure may include a first capacitor 110, a support layer 50, and an upper electrode plate 120 on a substrate 10. In an implementation, the first capacitor 110 may include a lower electrode 65, a dielectric pattern 75, and an upper electrode structure 100.

The first capacitor 110 may further include a first conductive pattern 25 contacting (e.g., directly contacting) the lower electrode 65, a first insulating interlayer 20 containing the first conductive pattern 25, and a first etch stop layer 30 on the substrate 10.

The substrate 10 may include silicon, germanium, silicon-germanium, or a III-V group compound semiconductor, e.g., GaP, GaAs, or GaSb. In an implementation, the substrate 10 may be a silicon-on-insulator (SOI) substrate or a germanium-on-insulator (GOI) substrate.

The first conductive pattern 25 may include, e.g., contact plugs, landing pads, or the like, and a plurality of first conductive patterns 25 may be spaced apart from each other in a horizontal direction substantially parallel to an upper surface of the substrate 10.

The first insulating interlayer 20 may include an oxide, e.g., silicon oxide or a low-k dielectric material, and the first conductive pattern 25 may include, e.g., a metal, a metal nitride, a metal silicide, doped polysilicon, or the like. A low-k dielectric material may for example be a material having a dielectric constant k less than that of silicon dioxide.

The first etch stop layer 30 may be on the first insulating interlayer 20. The first etch stop layer 30 may include an insulating nitride, e.g., silicon nitride, silicon boronitride, silicon carbonitride, or the like.

The lower electrode 65 may extend through the first etch stop layer 30, and may contact an upper surface of a corresponding one of the first conductive patterns 25. The lower electrode 65 may have shape of a pillar extending in a vertical direction substantially perpendicular to the upper surface of the substrate 10. In an implementation, the lower electrode 65 may have a shape of, e.g., a cup or a hollow cylinder.

The lower electrode 65 may include, e.g., a metal, a metal nitride, polysilicon doped with impurities, or the like.

The support layer 50 may be on a sidewall of the lower electrode 65, and may have a shape of a plate having lower and upper surfaces substantially parallel to an upper surface of the substrate 10. In an implementation, a plurality of support layers 50 may be spaced apart from each other in the vertical direction on the first etch stop layer 30.

The support layer 50 may include an insulating nitride, e.g., silicon nitride, silicon boronitride, silicon carbonitride, or the like.

The dielectric pattern 75 may contact a sidewall of each of the lower electrodes 65 between the first etch stop layer 30 and a lowermost one of the support layers 50 and between the support layers 50.

The dielectric pattern 75 may include an oxide of a metal. In an implementation, the dielectric pattern 75 may include an oxide of a metal having 4 valence electrons, e.g., hafnium or zirconium.

The upper electrode structure 100 may include a first upper electrode 85 and a second upper electrode 95 sequentially stacked on the dielectric pattern 75 between the first etch stop layer 30 and the lowermost one of the support layers 50 and between the support layers 50.

In an implementation, a work function of the first upper electrode 85 may be greater than a work function of the second upper electrode 95. In an implementation, a size of a grain of the second upper electrode 95 may be greater than a size of a grain of the first upper electrode 85, and accordingly, a resistance of the second upper electrode 95 may be smaller than a resistance of the first upper electrode 85.

In an implementation, each of the first and second upper electrodes 85 and 95 may include a metal nitride. In an implementation, a crystal orientation of the metal nitride in the first upper electrode 85 may be different from a crystal orientation of the metal nitride in the second upper electrode 95.

Each of the first and second upper electrodes 85 and 95 may include, e.g., titanium nitride, tantalum nitride, or the like. In an implementation, both of the first and second upper electrodes 85 and 95 may include titanium nitride, a primary crystal orientation of the titanium nitride of the first upper electrode 85 may be [111], and a primary crystal orientation of the titanium nitride of the second upper electrode may be [200].

Titanium nitride with the primary crystal orientation of [111] may have a larger work function than titanium nitride with the primary crystal orientation of [200], and accordingly, leakage current at an interface between the first upper electrode 85 and the dielectric pattern 75 may be reduced. In addition, titanium nitride with the primary crystal orientation of [200] may have a grain size greater than a grain size of titanium nitride with the primary crystal orientation of [111], and accordingly, the second upper electrode 95 may have a smaller resistance.

In an implementation, the second upper electrode 95 may further include a Group 15 element or a Group 16 element.

In an implementation, the first upper electrode 85 may have a thickness in a range of about 5Å to about 20Å (e.g. from 4.5Å to 20.5Å) or less, and the second upper electrode 95 may have a thickness in a range of about 10Å to about 50Å (e.g. from 9.5Å to 50.5Å).

In an implementation, a volume of the first upper electrode 85 may be in a range of about 10% to about 50% (e.g. from 9.5% to 50.5%) of a volume of the upper electrode structure 100.

The upper electrode structure 100 may include a material substantially the same as or different from a material of the lower electrode 65.

The upper electrode plate 120 may include, e.g., doped silicon-germanium.

As described above, each of the first and second upper electrodes 85 and 95 of the upper electrode structure 100 may include a metal nitride. In an implementation, crystallinities of the metal nitrides of the first and second upper electrodes 85 and 95, respectively, may be different from each other, and thus, the first and second upper electrodes 85 and 95 may have different electrical properties.

The upper electrode structure 100 may include the first upper electrode 85 having a relatively large work function, and thus, leakage current of the first upper electrode 85 to the dielectric pattern 75 may be reduced. In an implementation, the second upper electrode 95 of the upper electrode structure 100 may have a relatively low resistance, and thus, a total resistance of the upper electrode structure 100 may be low In an implementation, the upper electrode structure 100 including the first and second upper electrodes 85 and 95 may have improved electrical characteristics.

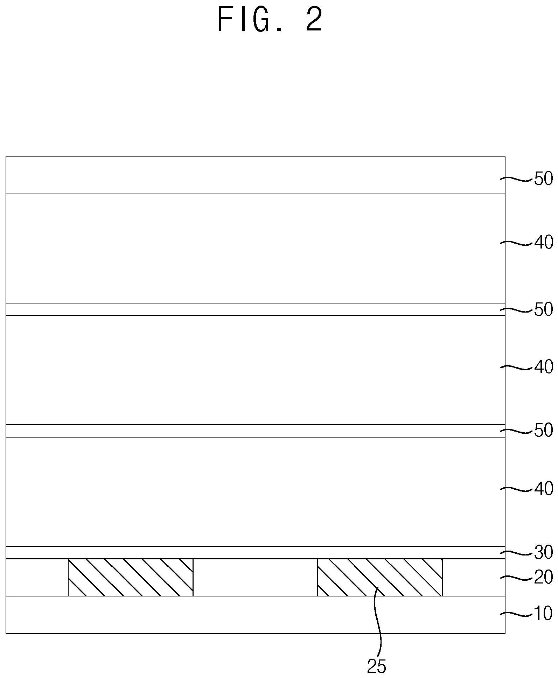

FIGS. 2 to 6 are cross-sectional views of stages in a method of forming a first capacitor structure in accordance with example embodiments.

Referring to FIG. 2, a first insulating interlayer 20 containing a first conductive pattern 25 may be formed on a substrate 10, a first etch stop layer 30 may be formed on the first insulating interlayer 20 and the first conductive pattern 25, and a mold layer 40 and a support layer 50 may be alternately and repeatedly stacked on the first etch stop layer 30.

In an implementation, a plurality of first conductive patterns 25 may be spaced apart from each other in a horizontal direction substantially parallel to an upper surface of the substrate 10.

The mold layer 40 may include an oxide, e.g., silicon oxide or a low-k dielectric material.

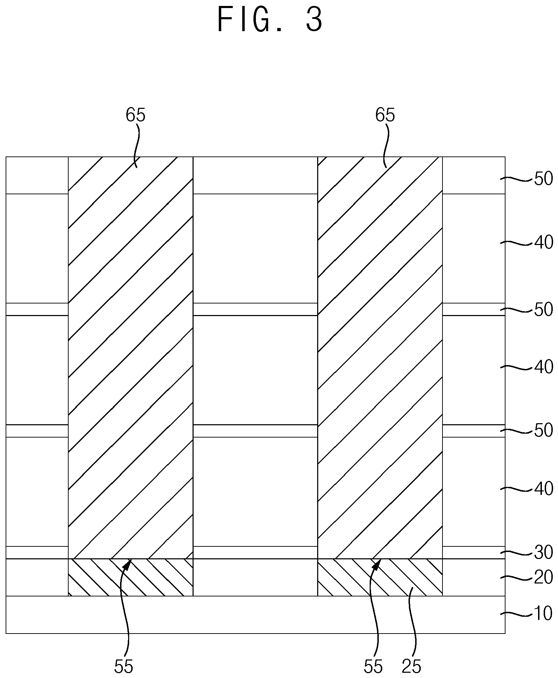

Referring to FIG. 3, a first opening 55 may be formed through the support layer 50, the mold layer 40 and the first etch stop layer 30 to expose an upper surface of each of the first conductive patterns 25.

A lower electrode layer may be formed on the upper surface of the first conductive pattern 25 exposed by the first opening 55, a sidewall of the first opening 55, and an upper surface of an uppermost one of the support layers 50 to fill the first opening 55.

In an implementation, the lower electrode layer may be formed by a deposition process, e.g., an atomic layer deposition (ALD) process, a chemical vapor deposition (CVD) process, or the like.

The lower electrode layer may be planarized until the upper surface of the uppermost one of the support layers 50 is exposed. Thus, a lower electrode 65 may be formed in each of the first openings 55.

The planarization process may include a chemical mechanical polishing (CMP) process or an etch back process.

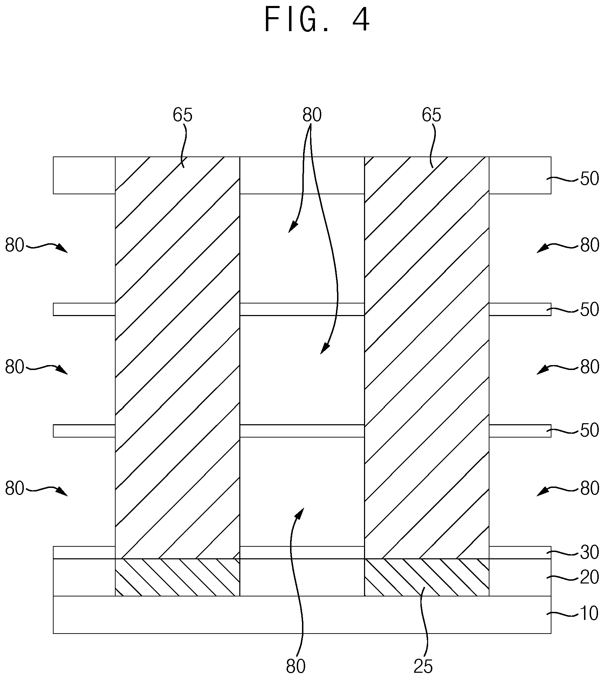

Referring to FIG. 4, the support layer 50 and the mold layer 40 may be partially removed to form a second opening exposing an upper surface of the first etch stop layer 30, and the mold layer 40 may be removed through the second opening.

In an implementation, the mold layer 40 may be removed by, e.g., a wet etching process, and a third opening 80 may be formed to expose a sidewall of each of the lower electrodes 65. In an implementation, the support layers 50 may remain on the sidewall of each of the lower electrodes 65.

The upper surface of the first etch stop layer 30 and surfaces of the support layers 50 may also be exposed by the third opening 80.

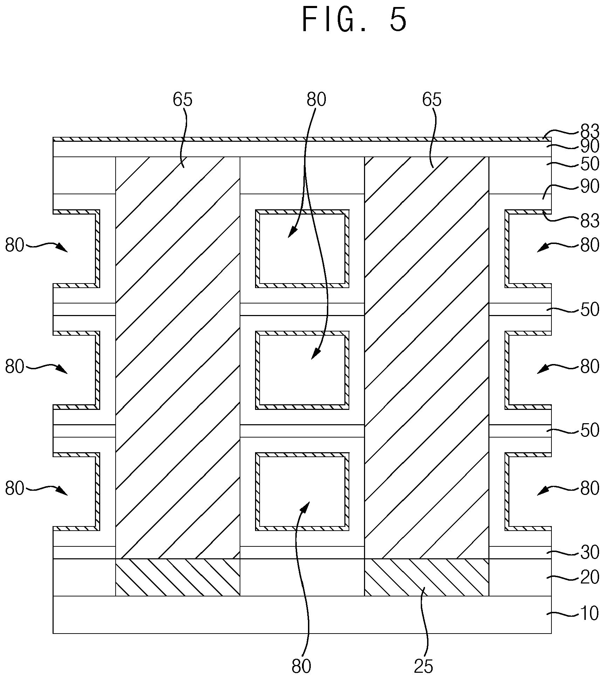

Referring to FIG. 5, a dielectric layer 90 may be formed on the sidewall of each of the lower electrodes 65, the upper surface of the first etch stop layer 30 and the surfaces of the support layers 50, and a first upper electrode layer 83 may be formed on the dielectric layer 90.

In an implementation, the first upper electrode layer 83 may be formed by a first deposition process, e.g., an atomic layer deposition (ALD) process. The first deposition process may include i) a first feeding process for supplying a metal precursor, ii) a purge process, iii) a second feeding process for supplying a nitrogen source, e.g., NH₃, and iv) a purge process. The processes of i) to iv) may be repeatedly performed.

In an implementation, the metal precursor may include, e.g., TiCl₄, TDMAT, TEMAT, TDEAT, or the like, and the first upper electrode layer 83 may include titanium nitride with a primary crystal orientation of [111],

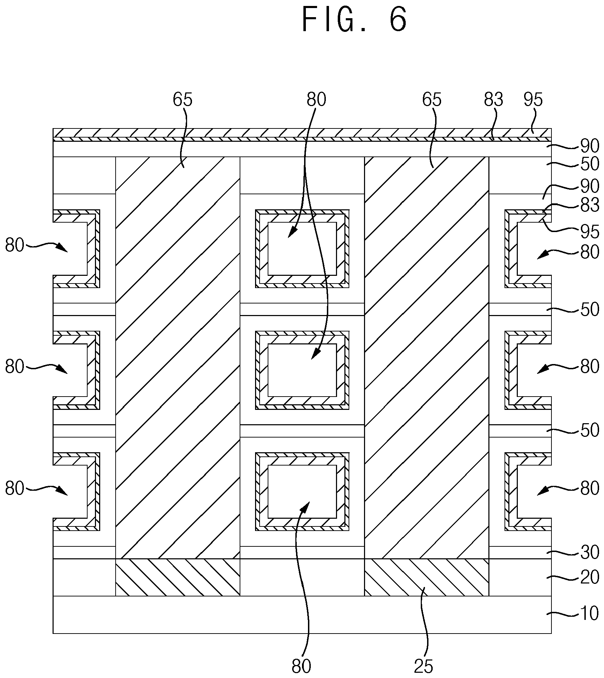

Referring to FIG. 6, a second upper electrode layer 95 may be formed on the first upper electrode layer 83.

In an implementation, the second upper electrode layer 95 may be formed by a second deposition process, e.g., an atomic layer deposition (ALD) process. The second deposition process may include i) a first feeding process for supplying an additive, ii) a purge process, iii) a second feeding process for supplying a metal precursor, iv) a purge process, v) a third feeding process for supplying a nitrogen source, e.g., NH₃, and vi) a purge process. The processes of i) to vi) may be repeatedly performed.

In an implementation, the metal precursor may include, for example, TiCl₄, TDMAT, TEMAT, TDEAT, or the like.

The additive may include an organic compound containing a Group 15 element, or an organic compound containing a Group 16 element. A metal of the metal precursor may coordinate with a lone pair of the Group 15 element or a lone pair of the Group 16 element of the additive, and thus, during the second deposition process for forming the upper electrode layer 95, the metal may be easily adsorbed compared to the first deposition process for forming the first upper electrode layer 83. Accordingly, the second upper electrode layer 95 may include a higher proportion of titanium nitride with a primary crystal orientation of [200] than titanium nitride with a primary crystal orientation of [111].

Thereafter, the additive may be replaced with nitrogen of the nitrogen source, but still, the additive may remain as an impurity, and thus, e.g., the second upper electrode layer 95 may further contain the Group 15 element or the Group 16 element.

The dielectric layer 90 and the first and second upper electrode layers 83 and 95 may also be stacked on an upper surface of the lower electrode 65 and the upper surface of the uppermost one of the support layers 50. These layers may be discontinuous layers in that they are deposited as part of a same process step, but do not form a single continuous layer (a portion shown in Figure 6 as surrounding a given third opening 80 may not be continuous with another such portion and/or with the portion stacked on the upper surface of the lower electrode 65).

Referring to FIG. 1 again, portions of the dielectric layer 90 and the first and second upper electrode layers 83 and 95 on the upper surface of the lower electrode 65 and the upper surface of the uppermost one of the support layers 50 may be removed.

Portions of the dielectric layer 90 and the first and second upper electrode layers 83 and 95 remaining in the third opening 80 may be referred to as a dielectric pattern 75 and first and second upper electrodes 85 and 95, respectively.

The lower electrode 65, the dielectric pattern 75 and the upper electrode structure 100 including the first and second upper electrodes 85 and 95 may collectively form a first capacitor 110.

An upper electrode plate 120 may be additionally formed on the first capacitor 110. The upper electrode plate 120 may include, e.g., doped silicon-germanium.

In an implementation, a top end of the third opening 80 may be covered by the upper electrode plate 120, and thus a first air gap 81 may be formed.

As described above, the first upper electrode layer 83 that may be formed by the first deposition process may include, e.g., titanium nitride with the primary crystal orientation of [111], and the second upper electrode layer 95 that may be formed by the second deposition process including the additional first feeding process for supplying the additive, may include, e.g., titanium nitride with the primary crystal orientation of [200]. Accordingly, the upper electrode structure 100 may include the first upper electrode 85 having a relatively large work function and the second upper electrode 95 having a relatively small resistance. Thus, the upper electrode structure 100 may have a reduced leakage current and a low resistance.

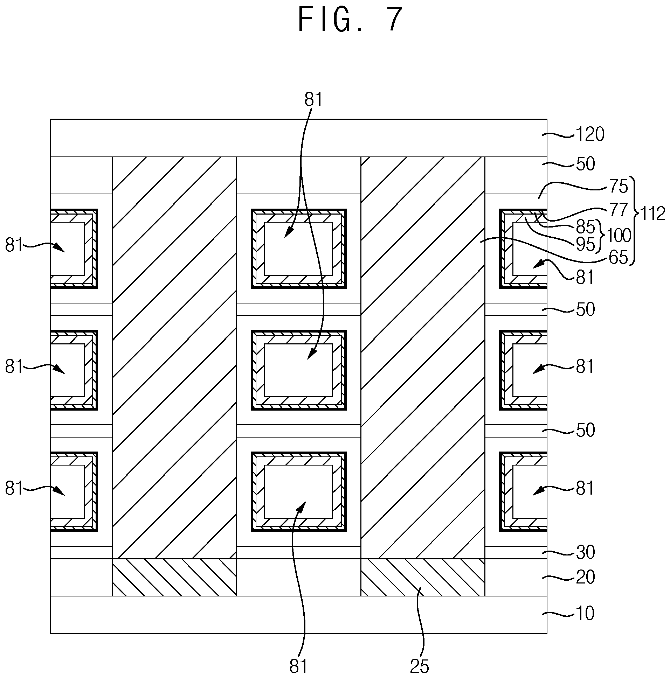

FIG. 7 is a cross-sectional view illustrating a second capacitor structure in accordance with example embodiments. The second capacitor structure may be substantially the same as or similar to the first capacitor structure, except for further including an interface oxide layer 77, and thus repeated explanations may be omitted herein.

Referring to FIG. 7, the second capacitor structure may include a second capacitor 112, and the second capacitor 112 may further include the interface oxide layer 77 between the dielectric pattern 75 and the upper electrode structure 100.

In an implementation, the interface oxide layer 77 may contact an upper surface of the dielectric pattern 75 instead of the first upper electrode 85.

In an implementation, the interface oxide layer 77 may include a metal oxide, e.g., TiO₂, Nb₂O₅, SnO₂, MoO₂, Sc₂O₃, Y₂O₄, B₂O₃, or the like.

In an implementation, a thickness of the interface oxide layer 77 may be in a range of about 1Å to about 10Å (for example from 0.5Å to 10.5Å).

After forming the dielectric layer 90 by the processes illustrated with reference to FIG. 6, the interface oxide layer 77 may be formed on the dielectric layer 90 by a deposition process, e.g., an atomic layer deposition (ALD) process, a chemical vapor deposition (CVD) process, or the like.

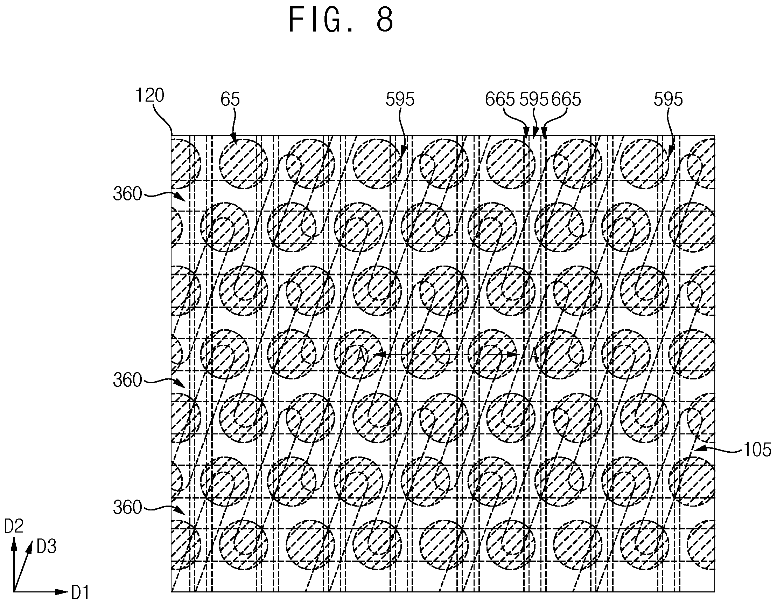

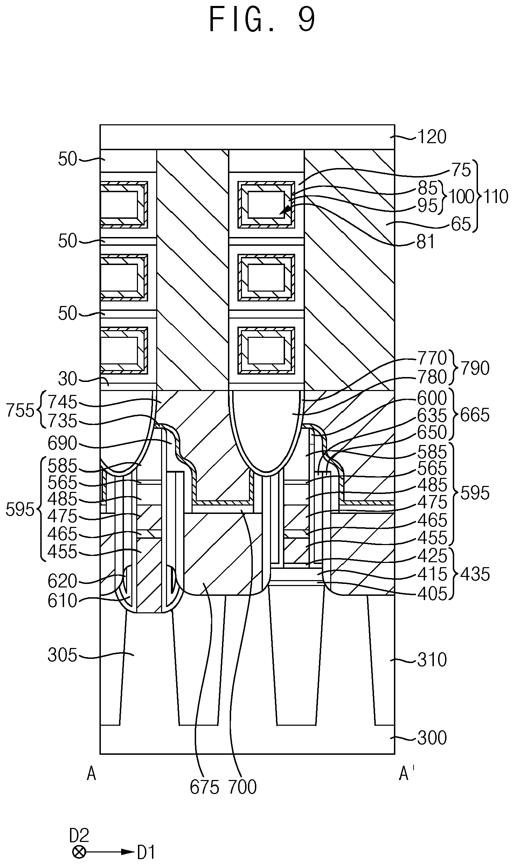

FIG. 8 is a plan view illustrating a semiconductor device in accordance with example embodiments, and FIG. 9 is a cross-sectional view taken along line A-A' of FIG. 8.

This semiconductor device may be an application of the first capacitor structure illustrated with reference to FIG. 1 to a DRAM device, and thus repeated explanations on the first capacitor structure may be omitted herein. In an implementation, the semiconductor device may include the second capacitor structure shown in FIG. 7 instead of the first capacitor structure.

Hereinafter, two directions among horizontal directions that are substantially parallel to an upper surface of a substrate 300, which may be substantially orthogonal to each other, may be referred as first and second directions D1 and D2, respectively, and a direction among or between the horizontal directions, which may have an acute angle with respect to each of the first and second directions D1 and D2, may be referred to as a third direction D3. Additionally, a direction substantially perpendicular to the upper surface of the substrate 300 may be referred to as a vertical direction. It will be appreciated that these directions are expressed relative to the device, and do not imply any particular orientation of that device.

Referring to FIGS. 8 and 9, the semiconductor device may include an active pattern 305, a gate structure 360, a bit line structure 595, a contact plug structure, and the first capacitor structure on the substrate 300.

The semiconductor device may further include an isolation pattern 310, a spacer structure 665, a fourth spacer 690, a second capping pattern 685, first and second insulation pattern structures 435 and 790, fifth and sixth insulation patterns 610 and 620, and a metal silicide pattern 700.

The active pattern 305 may extend in the third direction D3, and a plurality of active patterns 305 may be spaced apart from each other in the first and second directions D1 and D2. A sidewall of the active pattern 305 may be covered by the isolation pattern 310. The active pattern 305 may include substantially the same material as the substrate 300, and the isolation pattern 310 may include an oxide, e.g., silicon oxide.

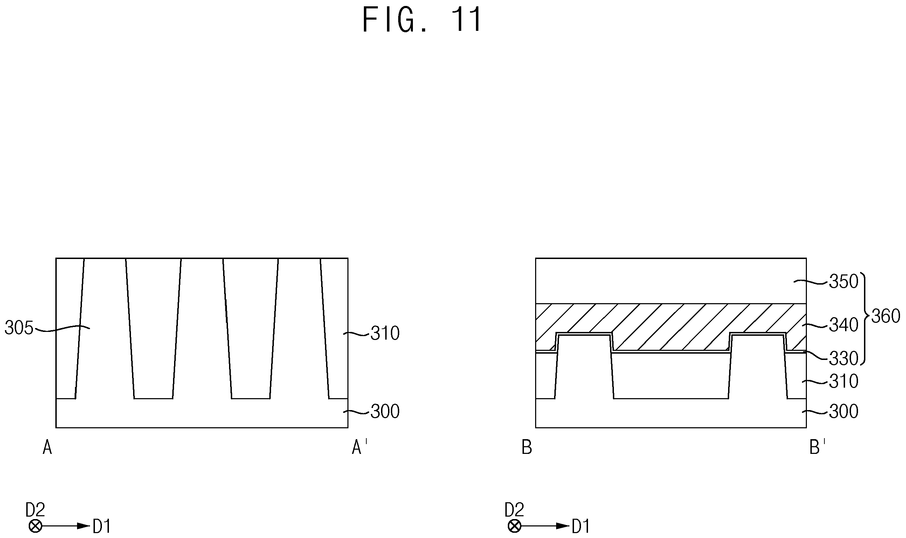

Referring to FIGS. 8 and 9 together with FIG. 11, the gate structure 360 may be formed in a second recess extending in the first direction D1 through upper portions of the active pattern 305 and the isolation pattern 310. The gate structure 360 may include a first gate insulation pattern 330 on a bottom and a sidewall of the second recess, a first gate electrode 340 on a portion of the first gate insulation pattern 330 on the bottom and a lower sidewall of the second recess, and a gate mask 350 on the first gate electrode 340 and filling an upper portion of the second recess.

The first gate insulation pattern 330 may include an oxide, e.g., silicon oxide, the first gate electrode 340 may include, e.g., a metal, a metal nitride, a metal silicide, or the like, and the gate mask 350 may include an insulating nitride, e.g., silicon nitride.

In an implementation, the gate structure 360 may extend in the first direction D1, and a plurality of gate structures 360 may be spaced apart from each other in the second direction D2.

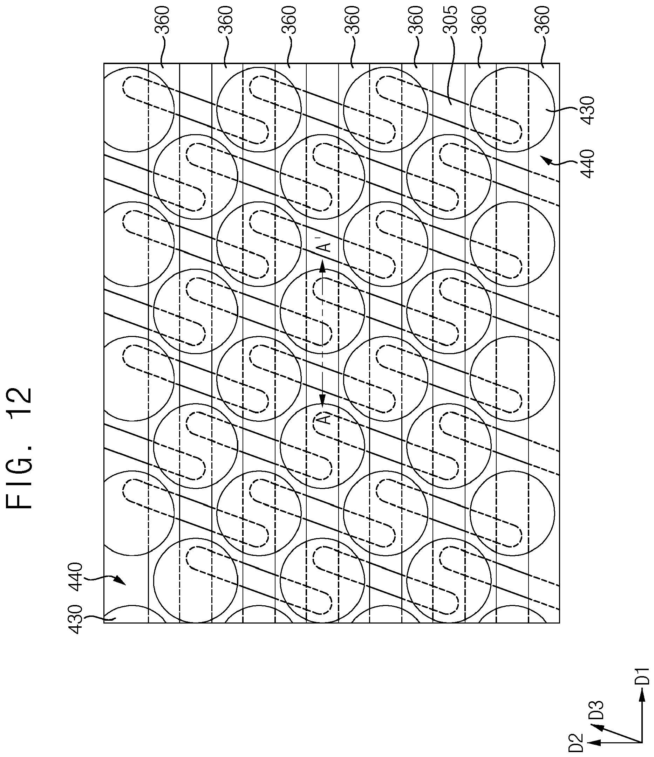

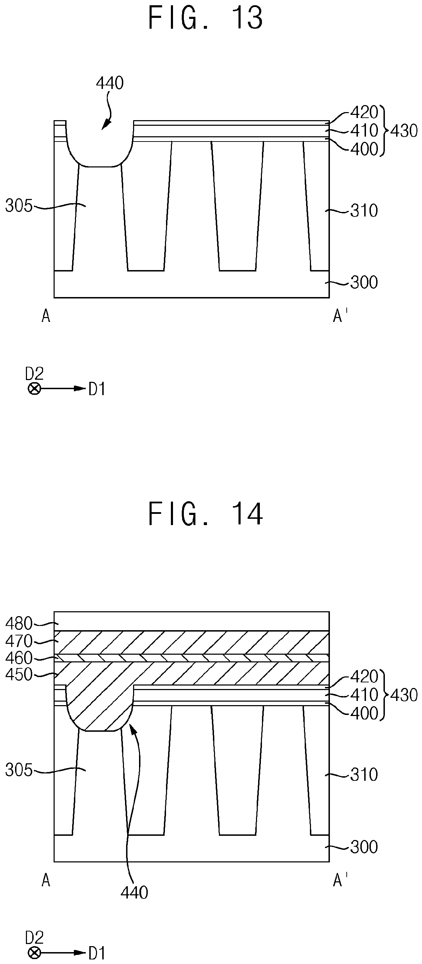

Referring to FIGS. 8 and 9 together with FIGS. 12 and 13, a fourth opening 440 extending through an insulating layer structure 430 and exposing upper surfaces of the active pattern 305, the isolation pattern 310 and the gate mask 350 of the gate structure 360 may be formed, and an upper surface of a central portion in the third direction D3 of the active pattern 305 may be exposed by the fourth opening 440.

In an implementation, an area of a bottom of the fourth opening 440 may be greater than an area of the upper surface of the active pattern 305. Thus, the fourth opening 440 may also expose an upper surface of a portion of the isolation pattern 310 adjacent to the active pattern 305. In an implementation, the fourth opening 440 may extend through upper portions of the active pattern 305 and the portion of the isolation pattern 310 adjacent thereto, and thus the bottom of the fourth opening 440 may be lower than an upper surface of each of opposite edge portions in the third direction D3 of the active pattern 305.

The bit line structure 595 may include a second conductive pattern 455, a first barrier pattern 465, a third conductive pattern 475, a first mask 485, a second etch stop pattern 565, and a first capping pattern 585 sequentially stacked in the vertical direction on the fourth opening 440 or the first insulation pattern structure 435. The second conductive pattern 455, the first barrier pattern 465 and the third conductive pattern 475 may collectively form a conductive structure, and the first mask 485, the second etch stop pattern 565 and the first capping pattern 585 may collectively form an insulation structure.

The second conductive pattern 455 may include, e.g., doped polysilicon, the first barrier pattern 465 may include a metal nitride, e.g., titanium nitride, or a metal silicon nitride, e.g., titanium silicon nitride, the third conductive pattern 475 may include a metal, e.g., tungsten, and each of the first mask 485, the second etch stop pattern 565 and the first capping pattern 585 may include an insulating nitride, e.g., silicon nitride.

In an implementation, the bit line structure 595 may extend (e.g., lengthwise) in the second direction D2 on the substrate 300, and a plurality of bit line structures 595 may be spaced apart from each other in the first direction D1.

The fifth and sixth insulation patterns 610 and 620 may be formed in the fourth opening 440, and may contact a lower sidewall of the bit line structure 595. The fifth insulation pattern 610 may include an oxide, e.g., silicon oxide, and the sixth insulation pattern 620 may include an insulating nitride, e.g., silicon nitride.

The first insulation pattern structure 435 may be formed on the active pattern 305 and the isolation pattern 310 under the bit line structure 595, and may include second, third and fourth insulation patterns 405, 415 and 425 sequentially stacked in the vertical direction. The second and fourth insulation patterns 405 and 425 may include an oxide, e.g., silicon oxide, and the third insulation pattern 415 may include an insulating nitride, e.g., silicon nitride.

The contact plug structure may include a lower contact plug 675, a metal silicide pattern 700 and an upper contact plug 755 sequentially stacked in the vertical direction on the active pattern 305 and the isolation pattern 310.

The lower contact plug 675 may contact the upper surface of each of opposite edge portions in the third direction D3 of the active pattern 305. In an implementation, a plurality of lower contact plugs 675 may be spaced apart from each other in the second direction D2, and a second capping pattern 685 may be formed between neighboring ones of the lower contact plugs 675 in the second direction D2. The second capping pattern 685 may include an insulating nitride, e.g., silicon nitride.

The lower contact plug 675 may include, e.g., doped polysilicon, the metal silicide pattern 700 may include, e.g., titanium silicide, cobalt silicide, nickel silicide, etc.

The upper contact plug 755 may include a second metal pattern 745 and a second barrier pattern 735 covering a lower surface of the second metal pattern 745. The second metal pattern 745 may include a metal, e.g., tungsten, and the second barrier pattern 735 may include a metal nitride, e.g., titanium nitride.

In an implementation, a plurality of upper contact plugs 755 may be spaced apart from each other in the first and second directions D1 and D2, and may be arranged in a honeycomb pattern or a lattice pattern in a plan view. Each of the upper contact plugs 755 may have a shape of, e.g., a circle, an ellipse, or a polygon in a plan view

The spacer structure 665 may include a first spacer 600 covering sidewalls of the bit line structure 595 and the fourth insulation pattern 425, an air spacer 635 on a lower outer sidewall of the first spacer 600, and a third spacer 650 on an outer sidewall of the air spacer 635, a sidewall of the first insulation pattern structure 435, and upper surfaces of the fifth and sixth insulation patterns 610 and 620.

Each of the first and third spacers 600 and 650 may include an insulating nitride, e.g., silicon nitride, and the air spacer 635 may include air.

The fourth spacer 690 may be formed on an outer sidewall of a portion of the first spacer 600 on an upper sidewall of the bit line structure 595, and may cover an upper end of the air spacer 635 and an upper surface of the third spacer 650. The fourth spacer 690 may include an insulating nitride, e.g., silicon nitride.

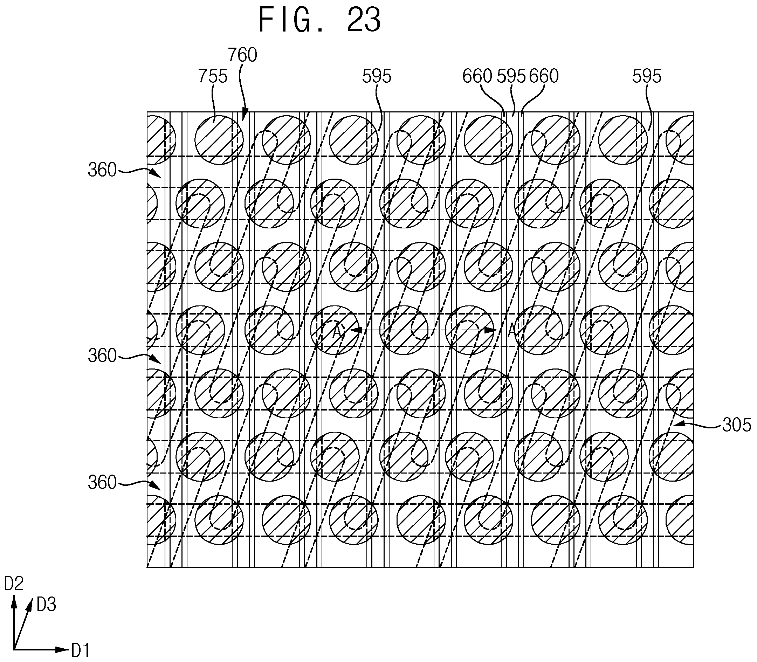

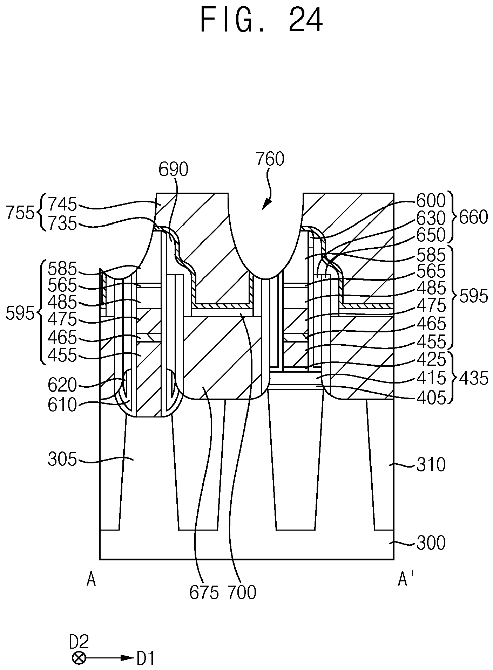

Referring to FIGS. 8 and 9 together with FIGS. 23 and 24, the second insulation pattern structure 790 may include a seventh insulation pattern 770 on an inner wall of a ninth opening 760, which may extend through the upper contact plug 755, a portion of the insulation structure of the bit line structure 595 and portions of the first, third and fourth spacers 600, 650 and 690 and surround the upper contact plug 755 in a plan view, and an eighth insulation pattern 780 on the seventh insulation pattern 770 and filling a remaining portion of the ninth opening 760. The upper end of the air spacer 635 may be closed by the seventh insulation pattern 770.

The seventh and eighth insulation patterns 770 and 780 may include an insulating nitride, e.g., silicon nitride.

The first etch stop layer 30 may be formed on the seventh and eighth insulation patterns 770 and 780, the upper contact plug 755 and the second capping pattern 685.

The first capacitor 110 may contact an upper surface of the upper contact plug 755.

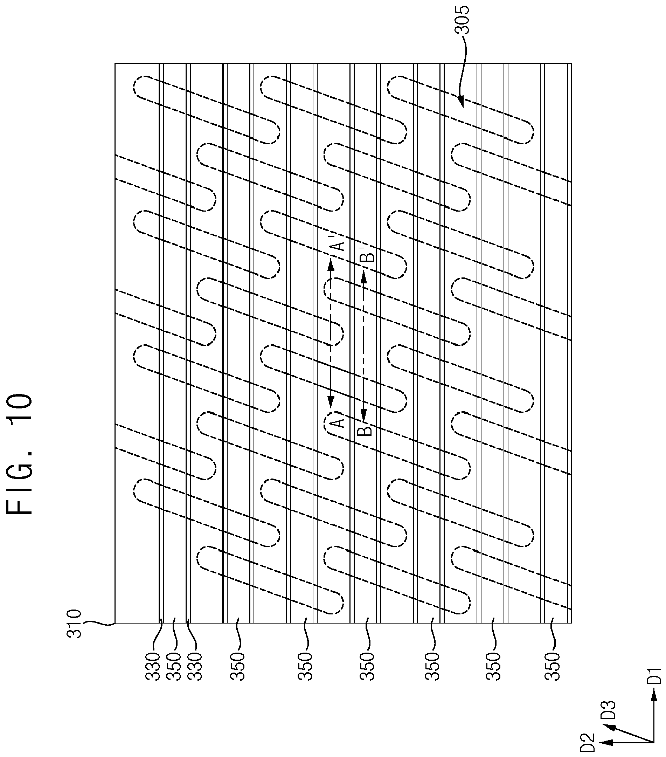

FIGS. 10 to 25 are plan views and cross-sectional views of stages in a method of manufacturing a semiconductor device according to example embodiments. Specifically, FIGS. 10, 12, 15, 19 and 23 are the plan views, FIG. 11 includes cross-sectional views taken along lines A-A' and B-B', respectively, of FIG. 10, and FIGS. 13-14, 16-18, 20-22 and 24-25 are cross-sectional views taken along lines A-A' of corresponding plan views, respectively.

The method of manufacturing the semiconductor device is an application of the method of forming the first capacitor structure described with reference to FIGS. 1 to 6 to a method of manufacturing a DRAM device, and repeated explanations of the method of forming the capacitor structure may be omitted herein.

Referring to FIGS. 10 and 11, an upper portion of a substrate 300 may be removed to form a first recess, and an isolation pattern 310 may be formed in the first recess.

As the isolation pattern 310 is formed on the substrate 300, an active pattern 305 of which a sidewall is covered by the isolation pattern 310 may be defined.

The active pattern 305 and the isolation pattern 310 on the substrate 300 may be partially etched to form a second recess extending in the first direction D1, and a gate structure 360 may be formed in the second recess. In an implementation, the gate structure 360 may extend in the first direction D1, and a plurality of gate structures may be spaced apart from each other in the second direction D2.

Referring to FIGS. 12 and 13, an insulating layer structure 430 may be formed on the active pattern 305, the isolation pattern 310, and the gate structure 360. The insulating layer structure 430 may include second to fourth insulating layers 400, 410, and 420 sequentially stacked.

The insulating layer structure 430 may be patterned, and the active pattern 305, the isolation pattern 310, and the gate mask 350 included in the gate structure 360 may be partially etched using the patterned insulating layer structure 430 as an etching mask to form a fourth opening 440. In an implementation, the insulating layer structure 430 may have a circular shape or an elliptical shape in a plan view, and a plurality of insulating layer structures 430 may be spaced apart from each other in the first and second directions D1 and D2. Each of the insulating layer structures 430 may overlap edge portions of ones of the active patterns 305 neighboring in the third direction D3, which may face each other, in a vertical direction substantially orthogonal to the upper surface of the substrate 300.

Referring to FIG. 14, a first conductive layer 450, a first barrier layer 460, a second conductive layer 470 and a first mask layer 480 may be sequentially stacked on the insulating layer structure 430, and the active pattern 305, the isolation pattern 310 and the gate structure 360 exposed by the fourth opening 440. The first conductive layer 450 may fill the fourth opening 440.

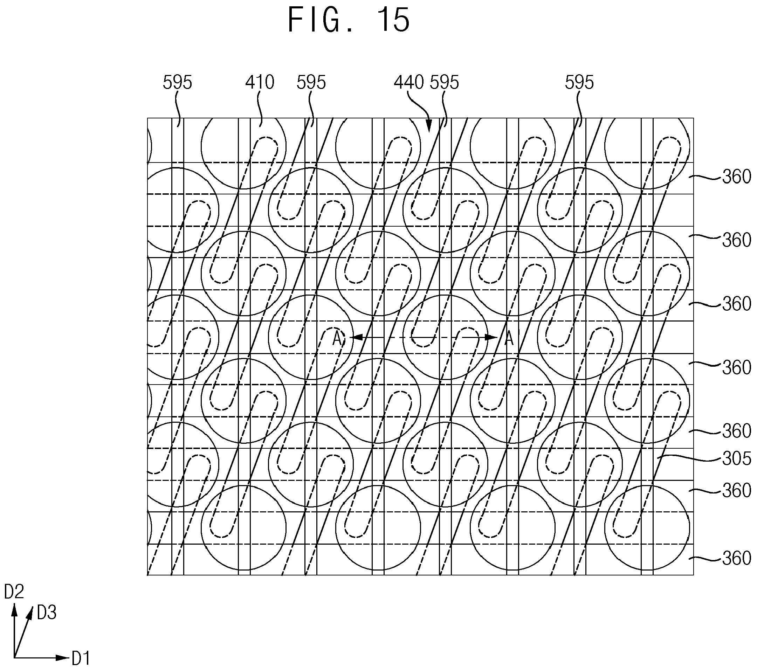

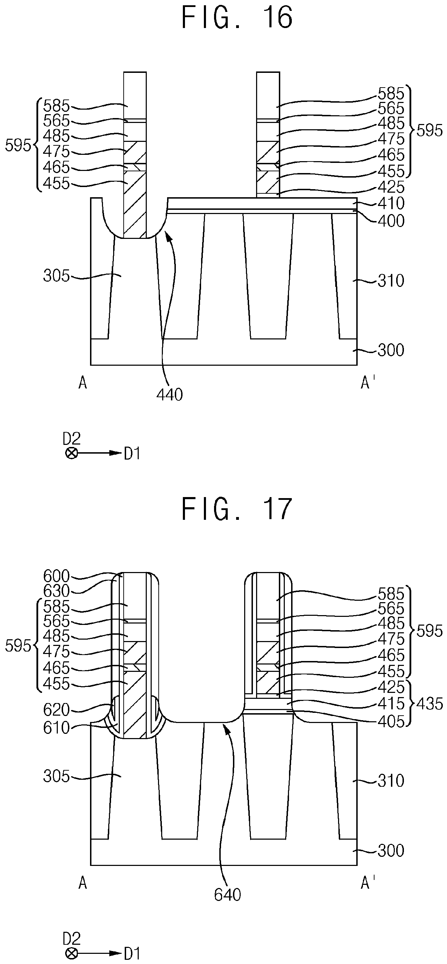

Referring to FIGS. 15 and 16, a second etch stop layer and a first capping layer may be sequentially formed on the conductive structure layer, the first capping layer may be etched to form a first capping pattern 585, and the second etch stop layer, the first mask layer 480, the second conductive layer 470, the first barrier layer 460 and the first conductive layer 450 may be sequentially etched using the first capping pattern 585 as an etching mask.

In an implementation, the first capping pattern 585 may extend in the second direction D2, and a plurality of first capping patterns 585 may be spaced apart from each other in the first direction D1.

As a result of the etching process, a second conductive pattern 455, a first barrier pattern 465, a third conductive pattern 475, a first mask 485, a second etch stop pattern 565 and the first capping pattern 585 may be formed on the fourth opening 440, and a fourth insulation pattern 425, the second conductive pattern 455, the first barrier pattern 465, the third conductive pattern 475, the first mask 485, the second etch stop pattern 565 and the first capping pattern 585 may be sequentially stacked on the third insulating layer 410 of the insulating layer structure 430 at an outside of the fourth opening 440.

Hereinafter, the second conductive pattern 455, the first barrier pattern 465, the third conductive pattern 475, the first mask 485, the second etch stop pattern 565 and the first capping pattern 585 sequentially stacked may be referred to as a bit line structure 595. The second conductive pattern 455, the first barrier pattern 465 and the third conductive pattern 475 may form a conductive structure, and the first mask 485, the second etch stop pattern 565 and the first capping pattern 585 may form an insulation structure. In an implementation, the bit line structure 595 may extend in the second direction D2, and a plurality of bit line structures 595 may be spaced apart from each other in the first direction D1.

Referring to FIG. 17, a first spacer layer may be formed on the substrate 300 on which the bit line structure 595 is formed, and fifth and sixth insulating layers may be sequentially formed on the first spacer layer.

The first spacer layer may also cover a sidewall of the fourth insulation pattern 425 under the bit line structure 595 on the third insulating layer 410, and the sixth insulating layer may fill a remaining portion of the fourth opening 440.

The fifth and sixth insulating layers may be etched by an etching process. In an implementation, the etching process may be a wet etching process using, e.g., phosphoric acid (H₂PO₃), SC1, and hydrofluoric acid (HF) as an etchant, and portions of the fifth and sixth insulating layers except for portions thereof in the fourth opening 440 may be removed. In an implementation, most portion of a surface of the first spacer layer, e.g., all portions of the surface of the first spacer layer except for a portion of the surface thereof in the fourth opening 440 may be exposed, and the fifth and sixth insulating layers remaining in the fourth opening 440 may form fifth and sixth insulation patterns 610 and 620, respectively.

A second spacer layer may be formed on the exposed surface of the first spacer layer and the fifth and sixth insulation patterns 610 and 620 in the fourth opening 440. The second spacer layer may be anisotropically etched to form a second spacer 630 covering a sidewall of the bit line structure 595 on the surface of the first spacer layer and on the fifth and sixth insulation patterns 610 and 620.

A dry etching process may be performed using the first capping pattern 585 and the second spacer 630 as an etching mask to form a fifth opening 640 exposing an upper surface of the active pattern 305, and upper surfaces of the isolation pattern 310 the gate mask 350 may also be exposed by the fifth opening 640.

As a result of the dry etching process, portions of the first spacer layer on upper surfaces of the first capping pattern 585 and the second insulating layer 410 may be removed, and thus a first spacer 600 may be formed on the sidewall of the bit line structure 595. As a result of the dry etching process, the second and third insulating layers 400 and 410 may be partially removed to remain as second and third insulation patterns 405 and 415, respectively, under the bit line structure 595. The second to fourth insulation patterns 405, 415 and 425 sequentially stacked under the bit line structure 595 may collectively form a first insulation pattern structure.

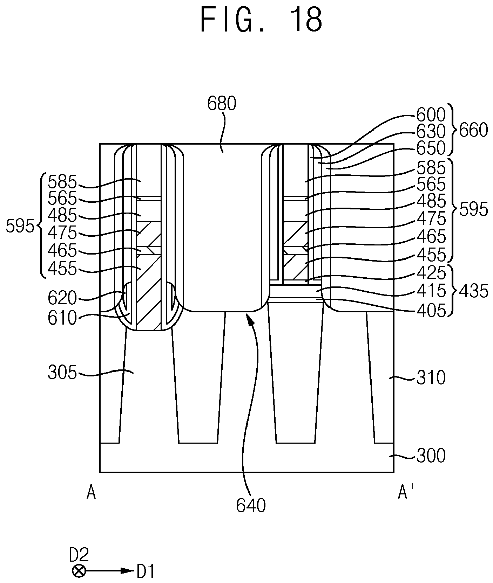

Referring to FIG. 18, a third spacer layer may be formed on an upper surface of the first capping pattern 585, an outer sidewall of the second spacer 630, portions of the upper surfaces of the fifth and sixth insulation patterns 610 and 620, and upper surfaces of the active pattern 305, the isolation pattern 310 and the gate mask 350 exposed by the fifth opening 640. The third spacer layer may be anisotropically etched to form a third spacer 650 covering the sidewall of the bit line structure 595.

The first to third spacers 600, 630 and 650 sequentially stacked on the sidewall of the bit line structure 595 in the horizontal direction may be referred to as a preliminary spacer structure 660.

A second sacrificial layer may be formed to fill the fifth opening 640 on the substrate 300 to a sufficient height (e.g. at or above a level of the upper surface of the first capping pattern 585), and an upper portion of the second sacrificial layer may be planarized until the upper surface of the first capping pattern 585 is exposed to form a second sacrificial pattern 680 in the fifth opening 640.

In an implementation, the second sacrificial pattern 680 may extend in the second direction D2, and a plurality of second sacrificial patterns 680 may be spaced apart from each other in the first direction D1 by the bit line structures 595. The second sacrificial pattern 680 may include, for example, an oxide such as silicon oxide.

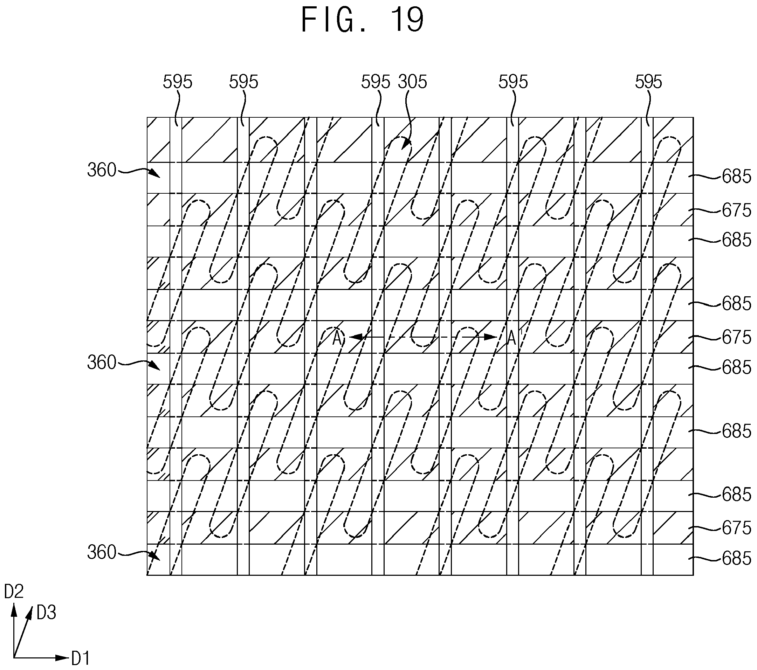

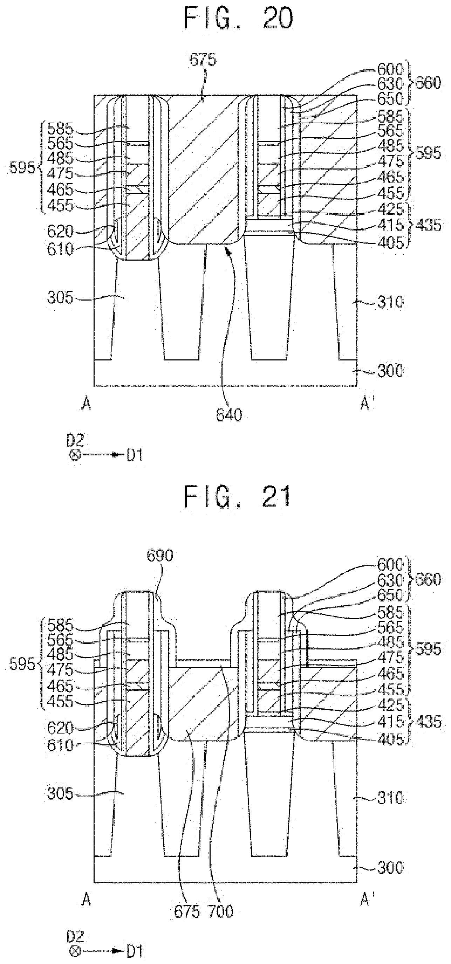

Referring to FIGS. 19 and 20, a second mask including a plurality of sixth openings, each of which may extend in the first direction D1, spaced apart from each other in the second direction D2 may be formed on the first capping pattern 585, the second sacrificial pattern 680 and the preliminary spacer structure 660, and may be etched using the second mask as an etching mask.

In an implementation, each of the sixth openings may overlap a region between the gate structures 360 in the vertical direction. As a result of the etching process, a seventh opening exposing upper surfaces of the active pattern 305 and the isolation pattern 310 may be formed between the bit line structures 595 on the substrate 300.

The second mask may be removed, a lower contact plug layer may be formed to fill the seventh opening to a sufficient height, and an upper portion of the lower contact plug layer may be planarized until the upper surface of the first capping pattern 585 and upper surfaces of the second sacrificial pattern 680 and the preliminary spacer structure 660 are exposed. Thus, the lower contact plug layer may be transformed into a plurality of lower contact plugs 675 spaced apart from each other in the second direction D2 between the bit line structures 595. In an implementation, the second sacrificial pattern 680 extending in the second direction D2 between the bit line structures 595 may be divided into a plurality of pieces in the second direction D2 by the lower contact plugs 675.

The second sacrificial pattern 680 may be removed to form an eighth opening, and a second capping pattern 685 may be formed to fill the eighth opening. In an implementation, the second capping pattern 685 may overlap the gate structure 360 in the vertical direction.

Referring to FIG. 21, an upper portion of the lower contact plug 675 may be removed to expose an upper portion of the preliminary spacer structure 660 on the sidewall of the bit line structure 595, and upper portions of the second and third spacers 630 and 650 of the exposed preliminary spacer structure 660 may be removed.

An upper portion of the lower contact plug 675 may be additionally removed. In an implementation, an upper surface of the lower contact plug 675 may be lower than upper surfaces of the second and third spacers 630 and 650.

A fourth spacer layer may be formed on the bit line structure 595, the preliminary spacer structure 660, the second capping pattern 685 and the lower contact plug 675, and may be anisotropically etched to form a fourth spacer 690 covering an upper portion of the preliminary spacer structure 660 on the sidewall of the bit line structure 595, and the upper surface of the lower contact plug 675 may be exposed by the etching process.

A metal silicide pattern 700 may be formed on the exposed upper surface of the lower contact plug 675. In an implementation, the metal silicide pattern 700 may be formed by forming a first metal layer on the first and second capping patterns 585 and 685, the fourth spacer 690 and the lower contact plug 675, performing a heat treatment thereon, and removing an unreacted portion of the first metal layer.

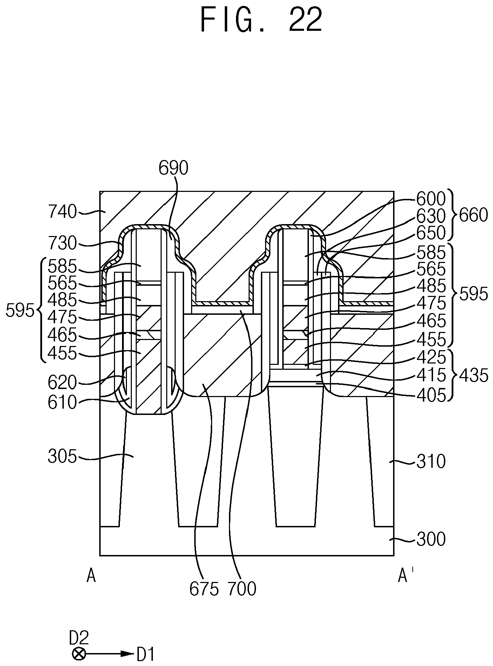

Referring to FIG. 22, a second barrier layer 730 may be formed on the first and second capping patterns 585 and 685, the fourth spacer 690, the metal silicide pattern 700 and the lower contact plug 675, and a second metal layer 740 may be formed on the second barrier layer 730 to fill a space between the bit line structures 595.

A planarization process may be performed on an upper portion of the second metal layer 740. The planarization process may include, e.g., a chemical mechanical polishing (CMP) process or an etch-back process.

Referring to FIGS. 23 and 24, the second metal layer 740 and the second barrier layer 730 may be patterned to form an upper contact plug 755. In an implementation, a plurality of upper contact plugs 755 may be formed, and a ninth opening 760 may be formed between the upper contact plugs 755.

The ninth opening 760 may be formed by partially removing the first and second capping patterns 585 and 685, the preliminary spacer structure 660 and the fourth spacer 690 as well as the second metal layer 740 and the second barrier layer 730.

The upper contact plug 755 may include a second metal pattern 745 and a second barrier pattern 735 covering a lower surface of the second metal pattern 745. In example embodiments, the upper contact plug 755 may have a shape of a circle, an ellipse, or a rounded polygon in a plan view, and the upper contact plugs 755 may be arranged, for example, in a honeycomb pattern in the first and second direction D1 and D2, in a plan view

The lower contact plug 675, the metal silicide pattern 700 and the upper contact plug 755 sequentially stacked on the substrate 300 may collectively form a contact plug structure.

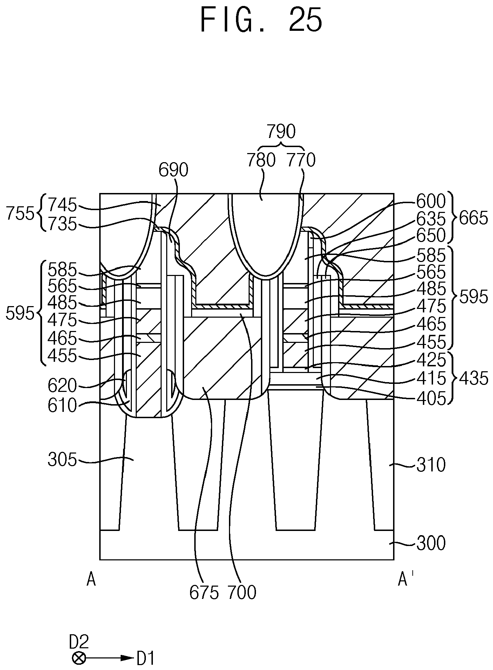

Referring to FIG. 25, the second spacer 630 included in the preliminary spacer structure 660 exposed by the ninth opening 760 may be removed to form an air gap, a seventh insulation pattern 770 may be formed on a bottom and a sidewall of the ninth opening 760, and an eighth insulation pattern 780 may be formed to fill a remaining portion of the ninth opening 760.

Each of the seventh and eighth insulation patterns 770 and 780 may form a second insulation pattern structure 790.

A top end of the air gap may be covered by the seventh insulation pattern 770, and thus an air spacer 635 may be formed. The first spacer 600, the air spacer 635 and the third spacer 650 may collectively form a spacer structure 665.

Referring to FIGS. 8 and 9 again, the first capacitor 110, the first etch stop layer 30, the support layer 50 and the upper electrode plate 120 may be formed by processes substantially the same as or similar to the processes described with reference to FIGS. 1 to 6.

The lower electrode 65 included in the first capacitor 110 may contact an upper surface of the upper contact plug 755.

By way of summation and review, as the integration degree of the DRAM device increases, a thickness of the upper electrode may become smaller, and accordingly, leakage current could increase.

According to an embodiment, leakage current of the upper electrode may be prevented and low resistance of the upper electrode may be secured.

One or more embodiments may provide a capacitor structure having improved characteristics.

One or more embodiments may provide a semiconductor device including a capacitor structure having improved characteristics.

In example embodiments, a capacitor structure according to example embodiments may include a lower electrode, a dielectric layer and an upper electrode structure sequentially stacked. The upper electrode structure may include a first electrode and a second electrode which are sequentially stacked and have different crystal structures from each other. The first upper electrode may have a crystal structure with a larger work function than the second upper electrode, and thus, leakage current at an interface where the first upper electrode contacts the dielectric layer may be reduced. The second upper electrode may have a crystal structure with larger grains than the first upper electrode, and thus, the second upper electrode may have a small resistance. Accordingly, leakage current may be reduced by the first upper electrode and the second upper electrode may lower the overall resistance of the upper electrode structure. Thus, the capacitor structure may have improved electrical characteristics.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the appended claims.

Examples of the present disclosure are set out in the following numbered clauses:
1. A capacitor structure, comprising:
   a lower electrode;
   a dielectric pattern on a sidewall of the lower electrode; and
   an upper electrode structure, the upper electrode structure including a first upper electrode and a second upper electrode sequentially stacked on a sidewall of the dielectric pattern,
   wherein:
   each of the first upper electrode and the second upper electrode includes a metal nitride, and
   the metal nitride included in the first upper electrode has a crystal orientation that is different from a crystal orientation of the metal nitride included in the second upper electrode, and
   a work function of the first upper electrode is greater than a work function of the second upper electrode.
2. The capacitor structure as claimed in clause 1, wherein the metal nitride includes titanium nitride.
3. The capacitor structure as claimed in clause 2, wherein:
   a primary crystal orientation of the titanium nitride of the first upper electrode is [111], and
   a primary crystal orientation of the titanium nitride of the second upper electrode is [200].
4. The capacitor structure as claimed in clause 2 or clause 3, wherein a resistance of the second upper electrode is lower than a resistance of the first upper electrode.
5. The capacitor structure as claimed in any preceding clause, wherein a grain size of the metal nitride included in the second upper electrode is greater than a grain size of the metal nitride included in the first upper electrode.
6. The capacitor structure as claimed in any preceding clause, wherein the second upper electrode further includes a Group 15 element or a Group 16 element.
7. The capacitor structure as claimed in any preceding clause, wherein:
   the first upper electrode has a thickness in a range of about 5Å to about 20Å, and
   the second upper electrode has a thickness in a range of about 10Å to about 50Å.
8. The capacitor structure as claimed in any preceding clause, wherein a volume of the first upper electrode is in a range of about 10% to about 50% of a volume of the upper electrode structure.
9. The capacitor structure as claimed in any preceding clause, further comprising an interface oxide layer between the dielectric pattern and the first upper electrode.
10. A capacitor structure, comprising:
   a lower electrode;
   a dielectric pattern on a sidewall of the lower electrode; and
   an upper electrode structure, the upper electrode structure including a first upper electrode and a second upper electrode sequentially stacked on a sidewall of the dielectric pattern,
   wherein:
      each of the first upper electrode and the second upper electrode includes titanium nitride,
      a primary crystal orientation of the titanium nitride of the first upper electrode is [111], and
      a primary crystal orientation of the titanium nitride of the second upper electrode is [200].
11. The capacitor structure as claimed in clause 10, wherein:
   the first upper electrode has a thickness in a range of about 5Å to about 20Å, and
   the second upper electrode has a thickness in a range of about 10Å to about 50Å.
12. The capacitor structure as claimed in clause 10 or clause 11, wherein a volume of the first upper electrode is in a range of about 10% to about 50% of a volume of the upper electrode structure.
13. The capacitor structure as claimed in any of clauses 10 to 12, wherein the second upper electrode further includes a Group 15 element or a Group 16 element.
14. The capacitor structure as claimed in any of clauses 10 to 13, wherein a resistance of the second upper electrode is lower than a resistance of the first upper electrode.
15. A semiconductor device, comprising:
   a substrate;
   an active pattern on the substrate;
   a gate structure extending in a first direction through an upper portion of the active pattern, the first direction being substantially parallel to an upper surface of the substrate;
   a bit line structure on a central portion of the active pattern, the bit line structure extending in a second direction substantially parallel to the upper surface of the substrate and substantially perpendicular to the first direction;
   a contact plug structure on each of opposite edge portions of the active pattern; and
   a capacitor structure on the contact plug structure,
   wherein:
      the capacitor structure includes:
         a lower electrode;
         a dielectric pattern on a sidewall of the lower electrode; and
         an upper electrode structure, the upper electrode structure including a first upper electrode and a second upper electrode sequentially stacked on a sidewall of the dielectric pattern,
      each of the first upper electrode and the second upper electrode includes a metal nitride,
      the metal nitride included in the first upper electrode has a crystal orientation that is different from a crystal orientation of the metal nitride included in the second upper electrode, and
      a work function of the first upper electrode is greater than a work function of the second upper electrode.
16. The semiconductor device as claimed in clause 15, wherein the metal nitride includes titanium nitride.
17. The semiconductor device as claimed in clause 16, wherein:
   a primary crystal orientation of the titanium nitride of the first upper electrode is [111], and
   a primary crystal orientation of the titanium nitride of the second upper electrode is [200].
18. The semiconductor device as claimed in any of clauses 15 to 17, wherein a resistance of the second upper electrode is lower than a resistance of the first upper electrode.
19. The semiconductor device as claimed in any of clauses 15 to 18, wherein a grain size of the metal nitride included in the second upper electrode is greater than a grain size of the metal nitride included in the first upper electrode.
20. The semiconductor device as claimed in any of clauses 15 to 19, wherein the second upper electrode further includes a Group 15 element or a Group 16 element.

## Claims

1. A capacitor structure, comprising:
a lower electrode;
a dielectric pattern on a sidewall of the lower electrode; and
an upper electrode structure, the upper electrode structure including a first upper electrode and a second upper electrode sequentially stacked on a sidewall of the dielectric pattern,
wherein:
each of the first upper electrode and the second upper electrode includes a metal nitride, and
the metal nitride included in the first upper electrode has a crystal orientation that is different from a crystal orientation of the metal nitride included in the second upper electrode, and
a work function of the first upper electrode is greater than a work function of the second upper electrode.

2. The capacitor structure as claimed in claim 1, wherein the metal nitride includes titanium nitride.

3. The capacitor structure as claimed in claim 2, wherein:
a primary crystal orientation of the titanium nitride of the first upper electrode is [111], and
a primary crystal orientation of the titanium nitride of the second upper electrode is [200].

4. The capacitor structure as claimed in claim 2 or claim 3, wherein a resistance of the second upper electrode is lower than a resistance of the first upper electrode.

5. The capacitor structure as claimed in any preceding claim, wherein a grain size of the metal nitride included in the second upper electrode is greater than a grain size of the metal nitride included in the first upper electrode.

6. The capacitor structure as claimed in any preceding claim, wherein the second upper electrode further includes a Group 15 element or a Group 16 element.

7. The capacitor structure as claimed in any preceding claim, wherein:
the first upper electrode has a thickness in a range of about 5Å to about 20Å, and
the second upper electrode has a thickness in a range of about 10Å to about 50Å.

8. The capacitor structure as claimed in any preceding claim, wherein a volume of the first upper electrode is in a range of about 10% to about 50% of a volume of the upper electrode structure.

9. The capacitor structure as claimed in any preceding claim, further comprising an interface oxide layer between the dielectric pattern and the first upper electrode.

10. A capacitor structure, comprising:
a lower electrode;
a dielectric pattern on a sidewall of the lower electrode; and
an upper electrode structure, the upper electrode structure including a first upper electrode and a second upper electrode sequentially stacked on a sidewall of the dielectric pattern,
wherein:
each of the first upper electrode and the second upper electrode includes titanium nitride,
a primary crystal orientation of the titanium nitride of the first upper electrode is [111], and
a primary crystal orientation of the titanium nitride of the second upper electrode is [200].

11. The capacitor structure as claimed in claim 10, wherein:
the first upper electrode has a thickness in a range of about 5Å to about 20Å, and
the second upper electrode has a thickness in a range of about 10Å to about 50Å.

12. The capacitor structure as claimed in claim 10 or claim 11, wherein a volume of the first upper electrode is in a range of about 10% to about 50% of a volume of the upper electrode structure.

13. The capacitor structure as claimed in any of claims 10 to 12, wherein the second upper electrode further includes a Group 15 element or a Group 16 element.

14. The capacitor structure as claimed in any of claims 10 to 13, wherein a resistance of the second upper electrode is lower than a resistance of the first upper electrode.
